Europäisches Patentamt

European Patent Office

Office européen des brevets

(11) Veröffentlichungsnummer : **0 080 613**
**B1**

(12) **EUROPÄISCHE PATENTSCHRIFT**

(45) Veröffentlichungstag der Patentschrift :
18.09.85

(21) Anmeldenummer : 82110270.4

(22) Anmeldetag : 08.11.82

(51) Int. Cl.⁴ : **H 03 K 17/96, B 66 B   1/46,**
**B 66 B   5/02**

(54) **Durch Berührung steuerbare kapazitive Schalteinrichtung.**

(30) Priorität : 26.11.81 CH 7570/81

(43) Veröffentlichungstag der Anmeldung :
08.06.83 Patentblatt 83/23

(45) Bekanntmachung des Hinweises auf die Patenterteilung : 18.09.85 Patentblatt 85/38

(84) Benannte Vertragsstaaten :
**AT DE FR GB IT**

(56) Entgegenhaltungen :
**AT-B-   362 446**
**US-A- 3 726 364**

(73) Patentinhaber : **INVENTIO AG**
**Seestrasse 55**
**CH-6052 Hergiswil NW (CH)**

(72) Erfinder : **Iten, Thomas, Dipl.-Ing.**
**Loretohöhe 2**
**CH-6300 Zug (CH)**

## Beschreibung

Die Erfindung betrifft eine durch Berührung steuerbare kapazitive Schalteinrichtung für kontaktlose Signalgabe, wobei die Schalteinrichtung einen Oszillator mit einem frequenzbestimmenden RC-Glied, einen dem Oszillator nachgeschalteten Schaltkreis und einen Berührungsknopf aufweist, und der Kondensator des RC-Gliedes einerseits über ein mindestens aus einem Widerstand bestehendes Koppelglied mit dem Berührungsknopf und andererseits mit dem Erdpotential verbunden ist, so dass bei Berührung des Berührungsknopfes eine Frequenzänderung des Oszillators und eine Änderung des am Ausgang des Schaltkreises vorhandenen diskreten Signales hervorrufbar ist.

Mit der österreichischen Patentschrift Nr. 362 446 ist eine derartige Schalteinrichtung bekannt geworden, bei welcher der Oszillator aus einem Schmitt-Trigger und einem frequenzbestimmenden RC-Glied besteht. Der dem Oszillator nachgeschaltete Schaltkreis ist aus drei in Serie geschalteten monostabilen Kippschaltungen gebildet. Das Koppelglied besteht aus einer Serieschaltung eines Kondensators und eines Widerstandes oder nur aus einem Widerstand. Der eine Anschluss des Kondensators des frequenzbestimmenden RC-Gliedes ist mit dem Erdpotential verbunden, so dass beim Berühren des Berührungsknopfes das Koppelglied parallel zum Kondensator des frequenzbestimmenden RC-Gliedes geschaltet wird.

Bei Anwendung derartiger Schalteinrichtungen als Stockwerkruf- oder Kabinenrufgeber bei Aufzügen ist es aus Sicherheitsgründen erforderlich, dass beispielsweise im Falle eines Brandes Fehlfunktionen der Geber verhindert werden. Diese Forderung kann vorstehend beschriebene Schalteinrichtung nicht erfüllen. Hierbei kann bei Ausbruch eines Feuers auf einem Stockwerk durch Hitzeeinwirkung die Luft ionisiert und eine leitende Verbindung zwischen dem Berührungsknopf und dem Erdpotential hergestellt werden. Eine Aufzugskabine, die einen derartig ausgelösten Stockwerkruf bedient, kann nun beispielsweise durch Versagen der Türsteuerung auf dem brennenden Stockwerk blockiert werden. Auch die Beschädigung oder Zerstörung von eingangs- oder ausgangsseitigen Bauteilen der Schalteinrichtung durch Hitzeeinwirkung kann die gleichen Auswirkungen haben.

Mit der US-A-3 726 364 ist eine als Stockwerkurfgeber verwendete, durch Berührung steuerbare Schalteinrichtung bekannt geworden die derart ausgebildet ist, dass sie durch Hitzeeinwirkung nicht aktiviert werden kann. Zu diesem Zweck ist ein Thermoauslöser vorgesehen, mittels welchem ein Relais von seiner Versorgungsspannung abgeschaltet werden kann. An den Ausgängen der Schalteinrichtung sind durch dieses Relais betätigbare Kontakte angeordnet, die sich beim Abschalten der Versorgungsspannung öffnen, so dass ein durch Hitzeeinwirkung möglicherweise entstehender Fahrbefehl nicht an die Aufzugssteuerung weitergeleitet werden kann. Ein Nachteil dieser Schalteinrichtung ist darin zu sehen, dass die Kontakte beim Abfall des Relais kleben bleiben können und so die Weiterleitung eines unter Hitzeeinwirkung erzeugten Fahrbefehles nicht unterbunden wird.

Die der Erfindung zugrunde liegende Aufgabe besteht darin, zwecks Behebung vorstehend beschriebener Nachteile eine Schalteinrichtung gemäss Oberbegriff zu schaffen, bei welcher Fehlschaltungen durch Hitzeeinwirkung sich nicht auf die Aufzugssteuerung auswirken können.

Zur Lösung dieser Aufgabe schlägt die Erfindung, wie sie im Anspruch gekennzeichnet ist, einen Thermoauslöser vor, der zwischen Berührungsknopf und Koppelglied geschaltet und unmittelbar am Berührungsknopf oder an einer den Berührungsknopf tragenden Montageplatte angeordnet ist. Ein weiterer Thermoauslöser ist zwischen den Ausgang eines dem Schaltkreis nachgeschalteten Verstärkers und eine Anschlusklemme eines Signalleiters der Aufzugssteuerung geschaltet.

Die mit der Erfindung erzielten Vorteile sind darin zu sehen, dass durch Hitzeeinwirkung ausgelöste Fahrbefehle für Fahrten zu brennenden Stockwerken nicht auftreten können, was bei von Personen besetzten Aufzugskabinen lebensrettend sein kann. Ein weiterer Vorteil ist in der Anordnung der Thermoauslöser zu sehen, wobei der eingangsseitig angeordnete die Entstehung von Fehlschaltungen durch Ionisation verhindert und der ausgangsseitig angeordnete die Weiterleitung gegebenenfalls durch defekte elektronische Elemente entstandener Fehlschaltungen verhindert.

Auf beiliegender Zeichnung ist ein Ausführungsbeispiel der Erfindung schematisch dargestellt, das im folgenden näher erläutert wird.

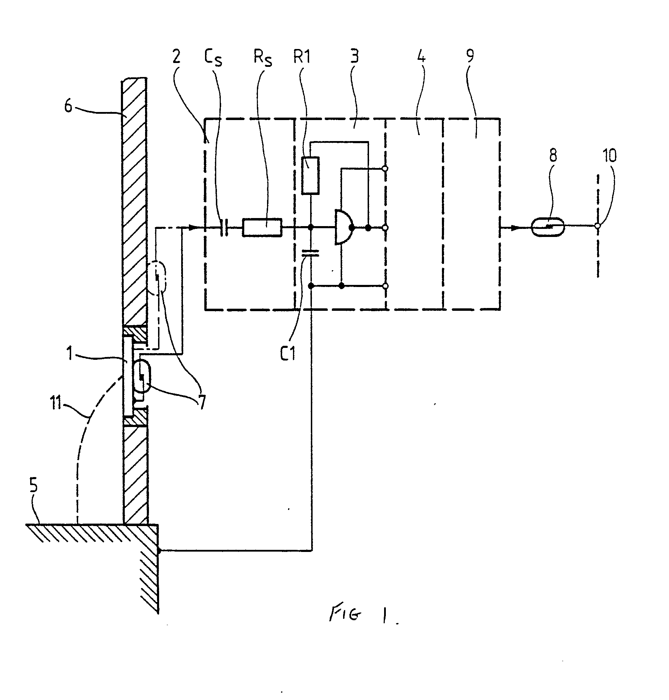

In der Zeichnung bildet eine aus der österreichischen Patentschrift Nr. 362 446 bekannte kapazitive Schalteinrichtung, welche aus einem Berührungsknopf 1, einem Koppelglied 2, einem Oszillator 3 und einem Schaltkreis 4 besteht, einen Stockwerkrufgeber für einen Aufzug. Der Berührungsknopf 1 des Stockwerkrufgebers ist an einer auf einem Stockwerk 5 befindlichen Montageplatte 6 befestigt. Das aus einem Kondensator $C_s$ und einem Widerstand $R_s$ bestehende Koppelglied 2 ist mit einem Anschluss des Kondensators C1 eines frequenzbestimmenden R/C-Gliedes ($R_1$, $C_1$) des Oszillators 3 verbunden, während dessen anderer Anschluss mit dem Stockwerkboden 5 in Verbindung steht. Zwischen den Berührungsknopf 1 und das Koppelglied 2 ist ein im Handel erhältlicher Thermoauslöser 7 geschaltet, der unmittelbar am Berührungsknopf 1 angeordnet ist, und der bei Auftreten einer bestimmten Umgebungstemperatur, beispielsweise 95°, die elektrische Verbindung zwischen Berührungsknopf 1 und Koppelglied 2 unterbricht. Ein weiterer Thermoauslöser 8 ist zwischen den Ausgang eines dem Schaltkreis 4 nachgeschalteten Verstärkers 9 und eine Anschlussklemme 10 für den Anschluss eines Signalleiters der Aufzugssteuerung geschaltet.

Im Normalbetrieb wird durch eine auf dem Stockwerk 5 stehende und den Berührungsknopf 1 berührende Person eine Verbindung 11 hergestellt und damit das Koppelglied 2 und der Kondensator C1 des Oszillators 3 parallel geschaltet, wodurch die Oszillatorfrequenz ändert und am Ausgang des Verstärkers 9 ein Signalwechsel auftritt. Bei starker Hitzeeinwirkung kann die Verbindung 11 zwischen Stockwerkboden 5 und Berührungsknopf 1 durch Ionisation der Luft hergestellt werden, oder es können durch Beschädigung oder Zerstörung von eingangs- oder ausgangsseitigen elektrischen Bauteilen des Stockwerkrufgebers Fehlschaltungen entstehen. Die Auslösetemperatur der Thermoauslöser 7, 8 ist so gewählt, dass die ein- und ausgangsseitigen elektrischen Verbindungen des Stockwerkrufgebers rechtzeitig unterbrochen werden, so dass Fehlschaltungen nicht entstehen oder weitergeleitet werden können.

## Patentanspruch

Durch Berührung steuerbare kapazitive Schalteinrichtung für kontaktlose Signalgabe, wobei die Schalteinrichtung einen Oszillator (3) mit einem frequenzbestimmenden RC-Glied ($R_1$, $C_1$), einen dem Oszillator (3) nachgeschalteten Schaltkreis (4) und einen Berührungsknopf (1) aufweist, und der Kondensator (C1) des RC-Gliedes ($R_1$, $C_1$) einerseits über ein mindestens aus einem Widerstand ($R_s$) bestehendes Koppelglied (2) mit dem Berührungsknopf (1) und andererseits mit dem Erdpotential verbunden ist, so dass bei Berührung des Berührungsknopfes (1) eine Frequenzänderung des Oszillators (3) und eine Änderung des am Ausgang des Schaltkreises (4) vorhandenen diskreten Signals hervorrufbar ist, dadurch gekennzeichnet, dass die Schalteinrichtung ein Stockwerkruf- oder Kabinenruf geber bei Aufzügen ist, dass ein Thermoauslöser (7) vorgesehen ist, der zwischen Berührungsknopf (1) und Koppelglied (2) geschaltet und unmittelbar am Berührungsknopf oder an einer den Berührungsknopf (1) tragenden Montageplatte (6) angeordnet ist, und dass ein weiterer Thermoauslöser (8) vorhanden ist, der zwischen den Ausgang eines dem Schaltkreis (4) nachgeschalteten Verstärkers (9) und eine Anschlussklemme (10) eines Signalleiters einer Aufzugssteuerung geschaltet ist.

## Claim

Touch-controlled capacitive switching device for contactless signal generation, wherein the switching device displays an oscillator (3) with a frequency-determining RC-member ($R_1$, $C_1$), a switching circuit (4) connected behind the oscillator (3) and a touch button (1), and the capacitor (C1) of the RC-member ($R_1$, $C_1$) is connected on the one hand with the touch button (1) through a coupling member (2) consisting at least of a resistor ($R_s$) and on the other hand with the earth potential, so that a change in frequency of the oscillator (3) and a change in the discrete signal present at the output of the switching circuit (4) are causable on touching of the touch button (1), characterised thereby, that the switching device is a generator of floor calls or cage calls for lifts, that a heat-sensitive switch (7) is provided, which is connected between the touch button (1) and the coupling member (2) and arranged directly at the touch button (1) or at a mounting plate (6) carrying the touch button (1), and that a further heat-sensitive switch (8) is provided, which is connected between the output of an amplifier (9) connected behind the switching circuit (4) and a connecting terminal (10) of a signal conductor of a lift control.

## Revendication

Dispositif de commutation capacitif pouvant être commandé par effleurement pour une transmission de signaux sans contact et dans lequel le dispositif de commutation comporte un oscillateur (3) muni d'un circuit RC ($R_1$, $C_1$) déterminant la fréquence, un circuit (4) monté en aval de l'oscillateur (4), et une touche à effleurement (1), et dans lequel le condensateur (C) du circuit RC ($R_1$, $C_1$) est relié d'une part à la touche à effleurement (1) par l'intermédiaire d'un organe de couplage (2) constitué par au moins une résistance (Rs) et d'autre part à la terre, de sorte que lors de l'effleurement de la touche à effleurement (1) une variation de la fréquence de l'oscillateur (3) et une variation du signal discret présent à la sortie du circuit (4) peuvent être provoquées, caractérisé en ce que le dispositif de commutation est un générateur d'appel d'étage ou de cabine pour ascenseurs, en ce qu'il est prévu un disjoncteur thermique qui est monté entre la touche à effleurement (1) et l'organe de couplage (2) et qui est disposé directement sur la touche à effleurement ou sur une plaque de montage (6) portant la touche à effleurement (1), et en ce qu'il est prévu un autre disjoncteur thermique (8) qui est monté entre la sortie d'un amplificateur (9) monté en aval du circuit (4) et une borne de raccordement (10) d'une ligne de transmission de signaux d'un dispositif de commande d'ascenseur.

FIG 1.